# EUROPEAN PATENT SPECIFICATION

(11) **EP 3 637 477 B1**
(45) Date of publication and mention of the grant of the patent: **13.07.2022**
(21) Application number: 17912708.9
(22) Date of filing: 21.06.2017
(51) Int. Cl.: H01L 31/05, H01L 31/0224, H01L 31/068

(54) **SOLAR CELL PHOTOVOLTAIC ARRAY**
SOLARZELLENFOTOVOLTAIKARRAY
BARRETTE PHOTOVOLTAÏQUE DE CELLULES SOLAIRES

(30) Priority: 07.06.2017 CN 201710424871
(43) Date of publication of application: 15.04.2020
(73) Proprietor: Suzhou Coop & Inno Green Energy Technology Co., Ltd., Suzhou, Jiangsu 215127 (CN); Tangshan Haitai New Energy Technology Co., Ltd., Yutian County Tangshan Hebei 064100 (CN)
(72) Inventor: ZHANG, Yujun, Suzhou Jiangsu 215127 (CN); TAO, Aibing, Suzhou Jiangsu 215127 (CN); TANG, Hong, Suzhou Jiangsu 215127 (CN); SHEN, Jia, Suzhou Jiangsu 215127 (CN)
(74) Representative: Baker, Thomas Edward
(86) International application number: PCT/CN2017/089372
(87) International publication number: WO 2018/223425

(56) References cited:
- CN-A- 101 867 321
- CN-A- 101 867 321
- CN-A- 103 367 482
- CN-A- 103 367 482
- CN-U- 202 009 010
- CN-U- 202 231 045
- CN-U- 203 733 815
- CN-U- 203 733 815
- CN-U- 204 596 801
- CN-U- 206 116 415
- US-A1- 2013 098 423

## Description

### Technical Field of the Invention

The present invention relates to solar cell technical field, and particular to a solar cell photovoltaic module and a solar cell photovoltaic assembly.

### Background of the Invention

With the rise of energy prices, the development and utilization of new energy sources has become the main topic of research in the nowadays energy field. Due to that solar energy has the advantages of no pollution, no regional restrictions, inexhaustible advantages and the like, research on solar power has become the main direction for the development and utilization of new energy sources. Using solar cell to generate electricity is a major way for people to use solar energy nowadays, however, existing solar cell has the following disadvantages.

1. The present arrangement of the solar cells is: the spacing between cells is 2 mm, the spacing between strings is 3 mm, the entire blank area of the solar cell assembly is relatively large, and the utilization rate of power generating is low. Although a stacked cell assembly is designed, and the power is improved, the stacked cell assembly increases the usage amount of the cells, and cells of the stacked part cannot generate electricity, resulting in a significant increase in the cost of the assembly, and therefore the cost performance is not high.

2. The present conventional assemblies adopt full-piece welding, and the currents of the cells are relatively large, which actually causes that the internal loss of the assemblies increases exponentially, and the power cannot be increased. In order to reduce the internal loss, the interconnectors employed by the design are thickened, and correspondingly, the hidden crack preventing capability of the cells is reduced, and meanwhile the cost of assembly is increased.

3. The present battery mainly employs 4 main grids or 5 main grids design, and the widths of the main grids are 1.1 mm and 0.8 mm, respectively, the widths of the main grids are relatively large, which reduces the actual irradiation area of the cells and then reduces the power of the cells; although the 12-grid cell assembly is designed to reduce the widths of the main grids, this assembly has a small welding contact surface, and a high potential risk of reliability, welding strip used in the 12 grid cells is relatively thick, and at present the thickness of most of the used copper wire material is 0.39 mm, which increases by 40% compared with the conventional welding strip with a thickness of 0.27mm, and in order to reduce hidden crack, the thickness of encapsulating material has to be further increased, thus increasing the cost of the assembly. In addition, the usage amounts of the main grid material and the interconnector material actually used are large, which further increase the cost. If a rounded welding strip is used, there is still a problem that a real surface contact cannot be achieved, resulting a long-term reducing of the reliability of connections between the main grids and the copper-based material actually. The performance of the product is not improved but the risk is.

4. In the design of conventional assemblies, the internal circuit is a series structure formed by a plurality of cells, and if an abnormality occurs in one string, the hot spot protection is usually conducted via a diode, and the overall power generation loss relates to the entire string. During the periods of sunrise in the morning and sunset in the afternoon, it faces the waste of power generation by shade, especially the waste of high-efficiency assemblies in this aspect is higher, and therefore, in the case of frequent shade of foreign matter such as bird droppings and leaves, the lack of cleanliness in time which results in the wastage of power generating capacity is a hidden trouble seriously affecting the income of the power station.

5. With the further improvement of the efficiency of the cells, the efficiency of the cells has been increased to 19.5% for polycrystalline PERC of mass production, 20.8% for monocrystalline cells, 21% for N-type double-sided cells, and 22.5% for heterojunction cells on average. The operating current of the overall cells rises rapidly. With the application and attenuation, the potential suitability between the cells inside the same assembly increases, with the addition of the external shading or internal hidden cracking and the like of the potential application process, how to improve the suitability of the cells in the assembly becomes a key element of the actual long-term power generation performance. In addition, for the double-sided cell assembly, the difference in the reflective environment at the back results in very great fluctuations and differences in reflection and power generation output, which is a factor that has to face and that results in the difference in suitability of the cells of the assembly during operation.

6. At present, in order to solve the abnormalities such as shade of cells or hot spots inside the assembly, the process employed is that a diode is provided between a string and another string, and current shunting and abnormal cell protection are realized through reverse conduction of the diode. However, the start-up of the diode actually separates the string circuit entirely, and reduces the voltage of the entire assembly according to the configuration of the diode proportionally. A local abnormality of a single cell leads to that the entire string of cells does not provide power generation to the working circuit due to being protected by the diode. The damage to power generation capacity is multiplied based on the number of cells of protected strings. In addition, as a centralized inverter circuit, the voltage drop of a single string further affects other parallel string circuits, resulting in the influence and damage of the final output of the combiner box. In addition, there is also an intelligent optimizing chip design for the strings, which monitors the voltage and current of each string and optimizes the string through the chip. This can properly reduce the damage of the string voltage, but it is still an improvement that stays at the string level. The increased cost of string level optimization design is relatively high, and the string level optimization design does not achieve large-scale acceptance in the market in the industry.

7. The amount of power generated by the assembly is directly related to the temperature at which the assembly is operating. The higher the operating temperature, the less power generated by the assembly. As described in 5#, the increase of the efficiency of the cells, the raising of the current, and the operating temperature of conventional assembly actually form the restraining factors of the generating capacity. The hot spots or hidden cracking of the assembly in the work process, or the inconformity of the attenuation difference between the cells of the assembly, will lead to internal loss and temperature rise of the assembly, and eventually lead to that the power generation capacity of the assembly cannot be optimized.

8. The latest technology of the present assembly is the process design of the overlapped assembly product. There is no welding strip on the surface of the actual overlapped assembly, and under the condition that the cells have hidden cracks, the entire string will suffer from obstructed current output, and the risk of hot spot failure will increase. In addition, the overlapped assembly itself s the cells to overlap and connect with each other to form a circuit for current output. How to compress the inter-cell spacing to close to zero in the assembly design and to improve the conversion efficiency of the assembly, the advantages and the short boards of the overlapped assembly are obvious. CN 206 116 415 U describes a solar cell photovoltaic module known in the prior art and such as described below in Example 1. CN 202 231 05 U describes a solar cell photovoltaic assembly, such as known in the prior art.

### Summary of the Invention

The present invention provides a solar cell photovoltaic assembly, to solve the above mentioned technical problems existing in the existing solar cell photovoltaic assemblies.

To solve the above mentioned technical problems, the present invention provides a solar cell photovoltaic assembly according to claim 1.

It should be noted that the cells can be obtained by cutting a present conventional cell, for example, dividing a conventional cell along parallel lines into 2 - 12 pieces, or directly obtaining cells of a required size through a silicon slice one-time ingot process.

In an embodiment, spacing between each two adjacent cells is 0 - 0.5 mm.

In an embodiment, widths of the cell-to-cell interconnectors are 0.5 - 0.8 mm, thicknesses thereof are 0.12 - 0.18 mm, and widths of the string-to-string interconnectors are 0.5 - 6 mm, thicknesses thereof are 0.1 - 0.4 mm.

In an embodiment, the string-to-string interconnectors employ tinned copper tapes, conductive tapes or transparent conductive films.

In an embodiment, a direction parallel to the long sides of the cells is transverse, and a direction parallel to the short sides of the cells is longitudinal, a transverse arrangement, i.e., a number of columns of the matrix-arranged cells is 2 - 6, and a longitudinal arrangement, i.e., a number of rows of the matrix-arranged cells is 5 - 40, the string-to-string interconnectors are arranged in a density of every 1 - 3 row(s) of cells.

To prevent disconnection of the assembly and thus paralysis resulting from one module failure, in the prior art, two adjacent solar cell photovoltaic modules are generally connected via a diode or via a virtual conductive wire and a diode, and a junction box is connected with an output via the bus bars or the bus bars and the virtual conductive wire. In this way, when one module fails, the connection can through the diode or the virtual conductive wire, that is, the failure module is short-circuited, to ensure the normal operation of other modules.

In an embodiment, the solar cell photovoltaic modules are arranged along the long sides of the cells, and the bus bars are parallel to the long sides of the cells.

It should be noted that the direction that the long side of the assembly is parallel to the long side of the cell is horizontal, and the direction that the long side of the assembly is parallel to the short side of the cell is vertical.

### Brief Description of the Drawings

Fig. 1 is a structure schematic diagram of a light receiving surface without arranging interconnectors of Example 1;
Fig. 2 is a structure schematic diagram of a back light surface of a solar cell photovoltaic module of Example 1;
Fig. 3 is a partial structure schematic diagram of a light receiving surface of the solar cell photovoltaic module of Fig. 2;
Fig. 4 is a connection schematic diagram between cell-to-cell interconnectors and cells of Example 1;
Fig. 5 is a structure schematic diagram of a back light surface of a horizontal type solar cell photovoltaic assembly of Embodiment 1;
Fig. 6 is a structure schematic diagram of a back light surface of a vertical type solar cell photovoltaic assembly of Embodiment 2.

Wherein:
10 - cell; 21 - main grid; 22 - fine grid; 30 - cell-to-cell interconnector; 31 - light receiving surface end; 32 - back light surface end; 33 - string-to-string interconnector.

### Detailed Description of Exemplary Embodiments

The exemplary embodiments of the present invention are explained in detail combining with the accompanying drawings so that purposes, features and advantages of the present invention can be more obvious and more understandable. It should be noted that the drawings of the present invention all adopt simplified forms and all use non-precise proportions, and are only used for the purpose of conveniently and clearly explaining the embodiments of the present invention.

### Example 1 not part of the present invention: Solar Cell Photovoltaic Module

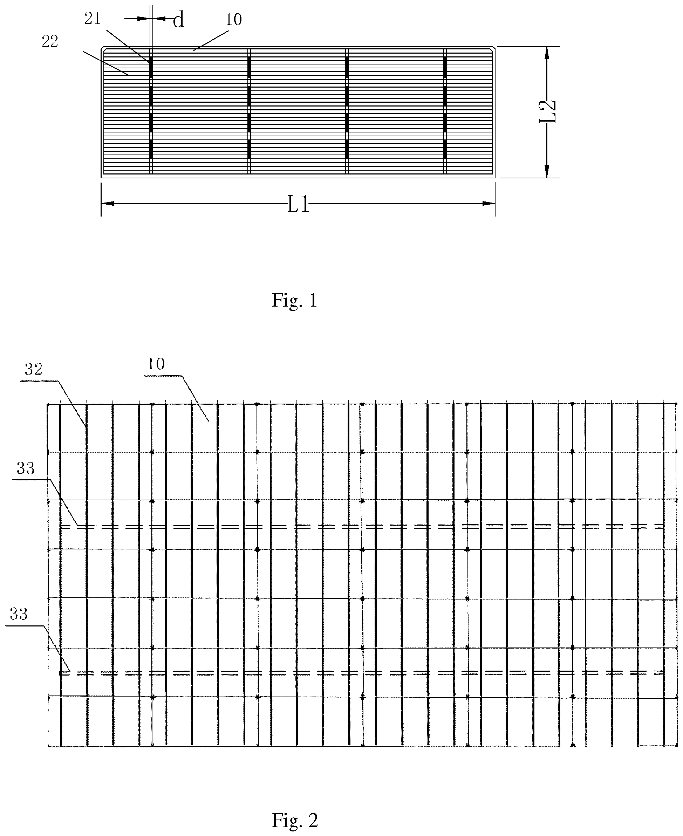

A solar cell photovoltaic module provided by the present invention comprises, a plurality of matrix-arranged cells, as shown in Fig. 1, a light receiving surface of each cell 10 is distributed with four longitudinal main grids 21 and 32 transverse fine grids 22, of course, the numbers of the main grids 21 and the fines grids 22 may increase or decrease according to requirement, and the present embodiment only gives an example, and the main grids 21 collect currents on the fine grids 22 connected thereto. The cell 10 is obtained by divided a normal cell evenly along 2 transverse parallel lines, that is, 1/3 of the normal cell, and is rectangular, wherein a length L1 of a long side thereof is 156.75±0.25 mm or is selected in the range of 156 - 160 mm, a length L2 of a short side thereof is 52.25±0.25 mm or is selected in the range of 31 - 54 mm, and the widths d of the main grids is 0.5 - 0.6 mm, and may broadened to 0.4 - 0.7 mm.

As shown in Fig. 2, the solar cell photovoltaic module comprises a plurality of matrix-arranged cells 10, a direction parallel to the long sides of the cells 10 is transverse, and a direction parallel to the short sides of the cells 10 is longitudinal, a transverse arrangement, i.e., a number of columns of the matrix of the cells 10 is 6, and a longitudinal arrangement, i.e., a number of rows of the matrix of the cells is 7.

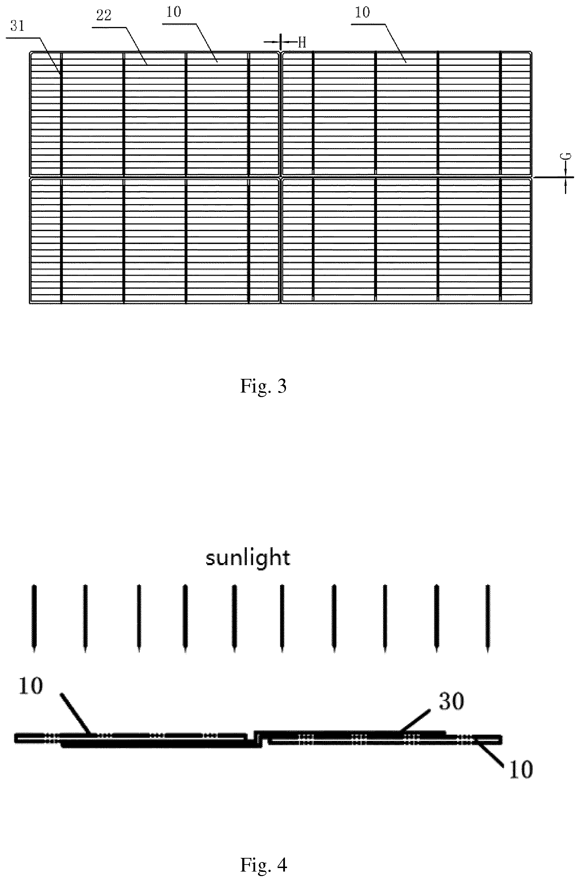

As shown in Fig. 3, enlarging a partial 2 × 2 matrix of the cells, spacing G between each two adjacent cells both in the transverse direction and in the longitudinal direction is 0 - 0.5 mm. The currents collected by the main grids 21 are transmitted through interconnectors that connect to the main grids 21, and the interconnectors are divided into cell-to-cell interconnectors 30 and string-to-string interconnectors 33.

As shown in Fig. 4, an end of each cell-to-cell interconnect 30 is a light receiving surface end 31, and the other end thereof is a back light surface end 32, as shown in Figs. 2 - 4, the light receiving surface end 31 is directly welded to one main grid 21 of one cell 10 on the right side, the back light surface end 33 is connected to a main grid 21 of a back light surface of another cell 10 on the left side, and the cell-to-cell interconnect 30 is used to connect the two cells in series. The string-to-string interconnectors 33 perpendicularly intersect the cell-to-cell interconnectors 30, and the string-to-string interconnect 33 are welded on the back light surface ends 32, of course, also can be welded on the light receiving surface ends 31, in the present embodiment, material of the string-to-string interconnectors 33 uses tinned copper tapes, and the string-to-string interconnectors 33 are arranged in a density of every three rows, that is, in every other two rows.

Widths of the cell-to-cell interconnectors 30 are in the range of 0.5 - 0.8 mm, thicknesses thereof are in the range of 0.12 - 0.18 mm; widths of the string-to-string interconnectors are in the range of 0.5 - 6 mm, thicknesses thereof are in the range of 0.1 - 0.4 mm.

It should be noted that the string-to-string interconnectors 33 may also use conductive tapes or transparent conductive films, wherein transparent conductive material may interconnected on the back light surface or the light receiving surface, to avoid the influence of the shade by itself. Such a design may be used in a double-sided cell, and may also be used in cell assembly applications such as no main grid process, welding strip process.

It should be noted that, for the encapsulation of the cells 10 provided in the present invention, double glass process and a narrow frame protection can be combined, to utilize the characteristics of high water resistance, such that the potential leakage of the cells 10 can be solved, and using a narrow frame protection, the convenient installation of assembly, low cost and high reliability can be achieved, especially for the technology of double-sided cells, the requirement of the front and back non-shading installation can resolved.

### Embodiment 1: Horizontal Solar Cell Photovoltaic Assembly

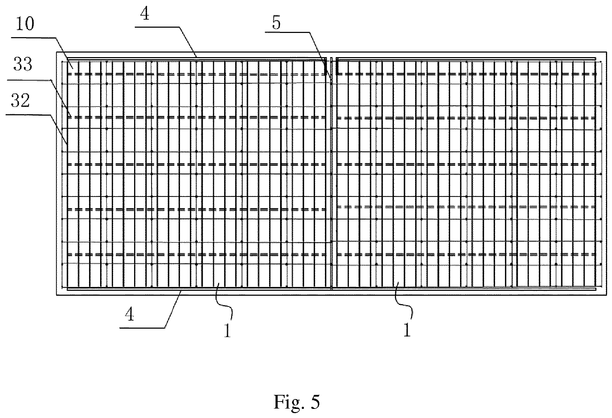

As shown in Fig. 5, the horizontal solar cell photovoltaic assembly comprises two solar cell photovoltaic modules 1 arranged side-by-side, that is, arranged along a direction of long sides of the cells 10, and bus bars 4 for collecting currents of the interconnectors, and the bus bars 4 are parallel to the long sides of the cells 10, the two solar cell photovoltaic modules 1 are connected to a virtual conductive wire 5 via diodes (not shown), and the virtual conductive wire 5 may be a conventional thin bus strip. The virtual conductive wire 5 and the cells 10 are isolated by insulating material. The insulating material may be conventional EPE material or a transparent insulating EPC or a transparent backplane, so as to ensure that the virtual conductive wire 5 does not directly contact the cells 10. A junction box (not shown) is connected with an output through the bus bars 4 and the virtual conductive wire 5, and here, the junction box adopts a three pin structure, and the working current of an employed single duodiode is between 15 A and 20 A.

The solar cell photovoltaic module 1 in the present embodiment differs from that in Example 1 by that the string-to-string interconnectors 33 are arranged in a density of every two rows, that is, in every other row.

It is recommended that the double-sided cell assembly uses transparent insulating conductive material and transparent conductive film material. The single-sided cell assembly may directly use non-transparent insulating conductive material and non-transparent conductive film material, directly arranged on the back side.

### Embodiment 2: Vertical Solar Cell Photovoltaic Assembly

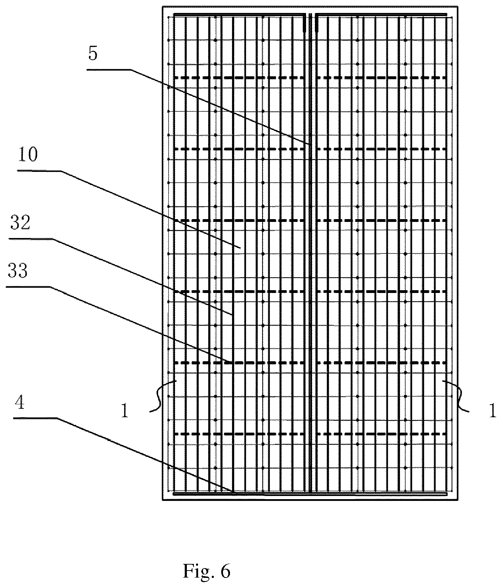

As shown in Fig. 6, it differs from Embodiment 1 by that, in the solar cell photovoltaic module 1 is arranged side-by-side, the number of columns of the matrix of the cells 10 is 3, and the row thereof is 20. A vertical solar cell photovoltaic assembly is configured. The string-to-string interconnectors 33 are also arranged in a density of every three rows, that is, in every other two rows.

It is obvious that those skilled in the art can make various changes or modifications on the present invention without depart from the scope of the present invention. Thus, the present invention is also intended to encompass these changes and modifications of the present invention which belong to the scope of the claims of the invention and equivalents thereof.

## Claims

1. A solar cell photovoltaic assembly, comprising more than two solar cell photovoltaic modules and bus bars for collecting currents of the interconnectors (30, 33);
each solar cell photovoltaic module comprising a plurality of matrix-arranged cells (10), wherein a plurality of main grids (21) and fine grids (22) are distributed on a light receiving surface of the cells (10), the main grids (21) collect currents on the fine grids (22) connected thereto, the currents collected by the main grids (21) are transmitted through interconnectors (30, 33) that connect to the main grids (21), the cells (10) are rectangular, lengths of long sides of the cells (10) are 156 - 160 mm, lengths of short sides of the cells (10) are 31 - 54 mm, and the main grids (21) are parallel to the short sides of the cells (10), and the widths of the main grids (21) are 0.4 - 0.7 mm, preferably 0.5 - 0.6 mm;
is **characterized in that**,
the interconnectors (30, 33) comprise cell-to-cell interconnectors (30) and string-to-string interconnectors (33), wherein the cell-to-cell interconnectors (30) transport currents between the cells (10) along a direction of the main grids (21), and the string-to-string interconnectors (33) connect parallel cell-to-cell interconnectors (30) in series;
the cell-to-cell interconnectors (30) are arranged parallel to main grids (21), and the string-to-string interconnectors (33) perpendicularly intersect with the cell-to-cell interconnectors (30) and connect the cell-to-cell interconnectors (30) intersecting therewith in series;
an end of each cell-to-cell interconnector (30) is a light receiving surface end (31), and the other end thereof is a back light surface end (32), the light receiving surface end (31) is connected to one main grid (21) of one cell (10), the back light surface end (32) is connected to a main grid (21) of a back light surface of another cell (10), the cell-to-cell interconnector (30) is used to connect two cells (10) in series, and each string-to-string interconnector (33) is welded on the back light surface end (32).

2. The solar cell photovoltaic assembly according to claim 1, wherein the solar cell photovoltaic modules are arranged along the long sides of the cells (10), and the bus bars are parallel to the long sides of the cells (10).

3. The solar cell photovoltaic assembly according to claim 1, wherein spacing between each two adjacent cells (10) is 0 - 0.5 mm.

4. The solar cell photovoltaic assembly according to claim 1, wherein widths of the cell-to-cell interconnectors (30) are 0.5 - 0.8 mm, thicknesses thereof are 0.12 - 0.18 mm, and widths of the string-to-string interconnects (33) are 0.5 - 6 mm, thicknesses thereof are 0.1 - 0.4 mm.

5. The solar cell photovoltaic assembly according to claim 1, wherein the string-to-string interconnectors (33) employ tinned copper tape, conductive tape or transparent conductive film.

6. The solar cell photovoltaic assembly according to any one of claims 1 - 5, wherein a direction parallel to the long sides of the cells (10) is transverse, and a direction parallel to the short sides of the cells (10) is longitudinal, a number of columns of the matrix-arranged cells is 2 - 6, and a number of rows of the matrix-arranged cells is 5 - 40.

## Patentansprüche

1. Solarzellenfotovoltaikbaugruppe, die mehr als zwei Solarzellenfotovoltaikmodule und Sammelschienen zum Sammeln von Strömen der Verbinder (30, 33) umfasst;
wobei jedes Solarzellenfotovoltaikmodul eine Vielzahl von in einer Matrix angeordneten Zellen (10) umfasst, wobei eine Vielzahl von Hauptgittern (21) und Feingittern (22) auf einer Lichtaufnahmefläche der Zellen (10) verteilt ist, die Hauptgitter (21) Ströme auf den damit verbundenen Feingittern (22) sammeln, die durch die Hauptgitter (21) gesammelten Ströme durch Verbinder (30, 33), die mit den Hauptgittern (21) verbunden sind, übertragen werden, die Zellen (10) rechteckig sind, die Längen von langen Seiten der Zellen (10) 156-160 mm betragen, die Längen von kurzen Seiten der Zellen (10) 31-54 mm betragen, die Hauptgitter (21) parallel zu den kurzen Seiten der Zellen (10) sind und die Breiten der Hauptgitter (21) 0,4-0,7 mm, bevorzugt 0,5-0,6 mm, betragen;
**dadurch gekennzeichnet, dass**
die Verbinder (30, 33) Zellverbinder (30) und Stringverbinder (33) umfassen, wobei die Zellverbinder (30) Ströme zwischen den Zellen (10) entlang einer Richtung der Hauptgitter (21) transportieren und die Stringverbinder (33) parallele Zellverbinder (30) in Reihe schalten;
die Zellverbinder (30) parallel zu Hauptgittern (21) angeordnet sind und die Stringverbinder (33) die Zellverbinder (30) senkrecht schneiden und die diese schneidenden Zellverbinder (30) in Reihe schalten;
ein Ende jedes Zellverbinders (30) ein Lichtaufnahmeflächenende (31) und das andere Ende davon ein Hinterlichtflächenende (32) ist, das Lichtaufnahmeflächenende (31) mit einem Hauptgitter (21) einer Zelle (10) verbunden ist, das Hinterlichtflächenende (32) mit einem Hauptgitter (21) einer Hinterlichtfläche einer anderen Zelle (10) verbunden ist, der Zellverbinder (30) dazu genutzt wird, um zwei Zellen (10) in Reihe zu schalten, und jeder Stringverbinder (33) auf das Hinterlichtflächenende (32) geschweißt ist.

2. Solarzellenfotovoltaikbaugruppe nach Anspruch 1, wobei die Solarzellenfotovoltaikmodule entlang der langen Seiten der Zellen (10) angeordnet sind und die Sammelschienen zu den langen Seiten der Zellen (10) parallel sind.

3. Solarzellenfotovoltaikbaugruppe nach Anspruch 1, wobei der Abstand zwischen je zwei benachbarten Zellen (10) 0-0,5 mm beträgt.

4. Solarzellenfotovoltaikbaugruppe nach Anspruch 1, wobei die Breiten der Zellverbinder (30) 0,5-0,8 mm, ihre Dicken 0,12-0,18 mm, die Breiten der Stringverbinder (33) 0,5-6 mm und ihre Dicken 0,1-0,4 mm betragen.

5. Solarzellenfotovoltaikbaugruppe nach Anspruch 1, wobei die Stringverbinder (33) ein verzinntes Kupferband, ein leitendes Band oder einen transparenten leitenden Film gebrauchen.

6. Solarzellenfotovoltaikbaugruppe nach einem der Ansprüche 1-5, wobei eine zu den langen Seiten der Zellen (10) parallele Richtung eine Querrichtung ist, eine zu den kurzen Seiten der Zellen (10) parallele Richtung eine Längsrichtung ist, eine Anzahl von Spalten der in einer Matrix angeordneten Zellen 2-6 beträgt und eine Anzahl von Zeilen der in einer Matrix angeordneten Zellen 5-40 beträgt.

## Revendications

1. Ensemble photovoltaïque de cellules solaires, comprenant au moins deux modules photovoltaïques de cellules solaires et des barres omnibus pour recueillir les courants des interconnecteurs (30, 33) ;
chaque module photovoltaïque de cellules solaires comprenant une pluralité de cellules disposées en matrice (10), dans lequel une pluralité de grilles principales (21) et de grilles fines (22) sont réparties sur une surface de réception de lumière des cellules (10), les grilles principales (21) recueillent les courants sur les grilles fines (22) qui leur sont connectées, les courants recueillis par les grilles principales (21) sont transmis par l'intermédiaire d'interconnecteurs (30, 33) qui se connectent aux grilles principales (21), les cellules (10) sont rectangulaires, les longueurs des côtés longs des cellules (10) sont de 156 à 160 mm, les longueurs des côtés courts des cellules (10) sont de 31 à 54 mm, et les grilles principales (21) sont parallèles aux côtés courts des cellules (10), et les largeurs des grilles principales (21) sont de 0,4 à 0,7 mm, de préférence de 0,5 à 0,6 mm ;
l'ensemble photovoltaïque étant **caractérisé en ce que**,
les interconnecteurs (30, 33) comprennent des interconnecteurs de cellule à cellule (30) et des interconnecteurs de chaîne à chaîne (33), dans lequel les interconnecteurs de cellule à cellule (30) transportent des courants entre les cellules (10) dans la direction des grilles principales (21) et les interconnecteurs de chaîne à chaîne (33) se connectent en série aux interconnecteurs de cellule à cellule (30) parallèles ;
les interconnecteurs de cellule à cellule (30) sont disposés parallèlement à grilles principales (21), et les interconnecteurs de chaîne à chaîne (33) croisent perpendiculairement les interconnecteurs de cellule à cellule (30) et se connectent en série aux interconnecteurs de cellule à cellule (30) croisant ceux-ci ;
une extrémité de chaque interconnecteur de cellule à cellule (30) est une extrémité de surface de réception de lumière (31), et son autre extrémité est une extrémité de surface de réflexion de lumière (32), l'extrémité de surface de réception de lumière (31) est connectée à une grille principale (21) d'une cellule (10), l'extrémité de surface de réflexion de lumière (32) est connectée à une grille principale (21) d'une surface de réflexion de lumière d'une autre cellule (10), l'interconnecteur de cellule à cellule (30) est utilisé pour connecter en série deux cellules (10), et chaque interconnecteur de chaîne à chaîne (33) est soudé sur l'extrémité de surface de réflexion de lumière (32).

2. Ensemble photovoltaïque de cellules solaires selon la revendication 1, dans lequel les modules photovoltaïques de cellules solaires sont disposés le long des côtés longs des cellules (10), et les barres omnibus sont parallèles aux côtés longs des cellules (10) .

3. Ensemble photovoltaïque de cellules solaires selon la revendication 1, dans lequel l'espacement entre deux cellules solaires adjacentes (10) est de 0 à 0,5 mm.

4. Ensemble photovoltaïque de cellules solaires selon la revendication 1, dans lequel les largeurs des interconnecteurs de cellule à cellule (30) sont de 0,5 à 0,8 mm, leurs épaisseurs sont de 0,12 à 0,18 mm, et les largeurs des interconnecteurs de chaîne à chaîne (33) sont de 0,5 à 6 mm et leurs épaisseurs sont de 0,1 à 0,4 mm.

5. Ensemble photovoltaïque de cellules solaires selon la revendication 1, dans lequel les interconnecteurs de chaîne à chaîne (33) utilisent une bande en cuivre étamé, une bande conductrice ou un film conducteur transparent.

6. Ensemble photovoltaïque de cellules solaires selon l'une quelconque des revendications 1 à 5, dans lequel une direction parallèle aux côtés longs des cellules (10) est transversale, et une direction parallèle aux côtés courts des cellules (10) est longitudinale, un nombre de colonnes des cellules disposées en matrice est de 2 à 6 et un nombre de lignes des cellules disposées en matrice est de 5 à 40.
